(19)

Europäisches
Patentamt
European
Patent Office
Office européen
des brevets

(11)  EP 3 231 507 A1

(12)  **EUROPEAN PATENT APPLICATION**
published in accordance with Art. 153(4) EPC

(43) Date of publication:
18.10.2017 Bulletin 2017/42

(51) Int Cl.:
*B01J 19/00* (2006.01)          *B29C 65/02* (2006.01)
*B81B 3/00* (2006.01)          *G01N 35/08* (2006.01)
*G01N 37/00* (2006.01)

(21) Application number: 15866983.8

(22) Date of filing: 29.10.2015

(86) International application number:
PCT/JP2015/080581

(87) International publication number:
WO 2016/092973 (16.06.2016 Gazette 2016/24)

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA**

(30) Priority: **10.12.2014 JP 2014250262**

(71) Applicant: Enplas Corporation
Kawaguchi-shi, Saitama 332-0034 (JP)

(72) Inventors:
• **SUNAGA, Nobuya**
**Saitama 332-0034 (JP)**
• **MURAKI, Koji**
**Saitama 332-0034 (JP)**

(74) Representative: Epping - Hermann - Fischer
Patentanwaltsgesellschaft mbH
Schloßschmidstraße 5
80639 München (DE)

(54) **FLUID HANDLING DEVICE AND METHOD FOR MANUFACTURING FLUID HANDLING DEVICE**

(57)      In the present invention, a fluid handling device has: a first substrate made of resin whereon a channel is formed in a first surface; a first film made of resin and joined to the first surface of the first substrate; a second film made of resin a first surface of which is joined to a second surface of the first substrate; and a second substrate made of resin and joined to a second surface of the second film. A recessed part overlapping the channel in a plane view is formed on the surface of the second substrate joined to the second film. The glass transition temperature $Tg_{1s}$ of the first substrate, the glass transition temperature $Tg_{1f}$ of the first film, the glass transition temperature $Tg_{2s}$ of the second substrate, and the glass transition temperature $Tg_{2f}$ of the second film satisfy $Tg_{1s}, Tg_{2s} > Tg_{1f}, Tg_{2f}$.

FIG. 2A

100

140 120 160 180 183 240

223

FIG. 2B

100

232 231
124 162 182 125 161 181

180
160
120
140

FIG. 2C

## Description

Technical Field

The present invention relates to a fluid handling device and a method of manufacturing the fluid handling device.

Background Art

In recent years, microchannel chips have been used to accurately and speedily analyze a trace amount of a substance such as a protein or a nucleic acid. Microchannel chips have an advantage in that only a small amount of a reagent or a sample is required, and thus are expected to be used for various uses such as laboratory tests, food tests, and environment tests.

In such a microchannel chip, a microchannel which allows a reagent or a sample to flow therethrough is formed by bonding a substrate and a film together (see, for example, PTL 1).

A channel device (microchannel chip) disclosed in PTL 1 includes a substrate for a first channel device, a substrate for a second channel device, and a plastic film. A groove which will become a channel is formed in one surface of the substrate for a first channel device. In the channel device disclosed in PTL 1, one surface of the substrate for a second channel device and one surface of the plastic film are joined by thermal fusing. Subsequently, the surface of the substrate for a first channel device, in which the groove is formed, and the other surface of the plastic film are joined by thermal fusing. It is considered that a method of manufacturing the channel device disclosed in PTL 1 performs thermal fusing at a temperature considerably higher than the glass transition temperature of the plastic film to thereby strongly join the substrate for a first channel device and the substrate for a second channel device.

Citation List

Patent Literature

PTL 1
Japanese Patent Application Laid-Open No. 2008-304352

Summary of Invention

Technical Problem

The method of manufacturing a channel device disclosed in PTL 1 joins a substrate for a first channel device and a substrate for a second channel device via a plastic film, which are not as flexible as the plastic film. It is considered that, during such a process, thermal fusing is performed at a temperature considerably higher than the glass transition temperature of the plastic film for firmly closing the groove with the plastic film to form a channel. Accordingly, there is a disadvantage such that the plastic film deformed by heat to become flowable enters inside the groove to cause deformation of the shape of the channel.

An object of the present invention is to provide a fluid handling device in which substrates are suitably joined via film(s) without the shape of a channel being deformed, and a method of manufacturing the device.

Solution to Problem

A fluid handling device of the present invention includes a resin-made first substrate having a first surface in which a groove is formed; a resin-made first film joined to the first surface of the first substrate; a resin-made second film having a first surface joined to a second surface of the first substrate, the second surface of the first substrate being in a front-rear relation with the first surface of the first substrate; and a resin-made second substrate joined to a second surface of the second film, the second surface of the second film being in a front-rear relation with the first surface of the second film, in which a recess overlapping the groove in plan view is formed in a surface of the second substrate, the surface being joined to the second film, and following expression (1) is satisfied

$$ Tg_{1s}, Tg_{2s} > Tg_{1f}, Tg_{2f} \cdots (1) $$

where $Tg_{1s}$ represents a glass transition temperature of the first substrate, $Tg_{1f}$ represents a glass transition temperature of the first film, $Tg_{2s}$ represents a glass transition temperature of the second substrate, and $Tg_{2f}$ represents a glass transition temperature of the second film.

Further, the method of the present invention for manufacturing a fluid handling device is a method of manufacturing the fluid handling device according to the present invention, in which joining between the first film and the first substrate, joining between the first substrate and the second film, and joining between the second film and the second substrate are each performed by thermal fusing.

Advantageous Effects of Invention

According to the present invention, it is possible to provide a fluid handling device in which substrates are suitably joined without the shape of a channel being deformed.

Brief Description of Drawings

FIG. 1 is a plan view of a microchannel chip according to Embodiment 1;

FIGS. 2A to 2C are sectional views of the microchannel chip;

FIGS. 3A to 3E illustrate a configuration of a first substrate;

FIGS. 4A to 4D illustrate a configuration of a first film;

FIGS. 5A to 5D illustrate a configuration of a second film;

FIGS. 6A to 6E illustrate a configuration of a second substrate;

FIGS. 7A and 7B illustrate a configuration of a microchannel chip according to Embodiment 2;

FIGS. 8A and 8B illustrate steps of manufacturing method 1; and

FIGS. 9A and 9B illustrate steps of manufacturing method 2.

Description of Embodiments

In the following, embodiments of the present invention will be described in detail with reference to the accompanying drawings. In the following description, as a typical example of a fluid handling device of the present invention, a microchannel chip will be described.

[Embodiment 1]

(Configuration of Microchannel Chip)

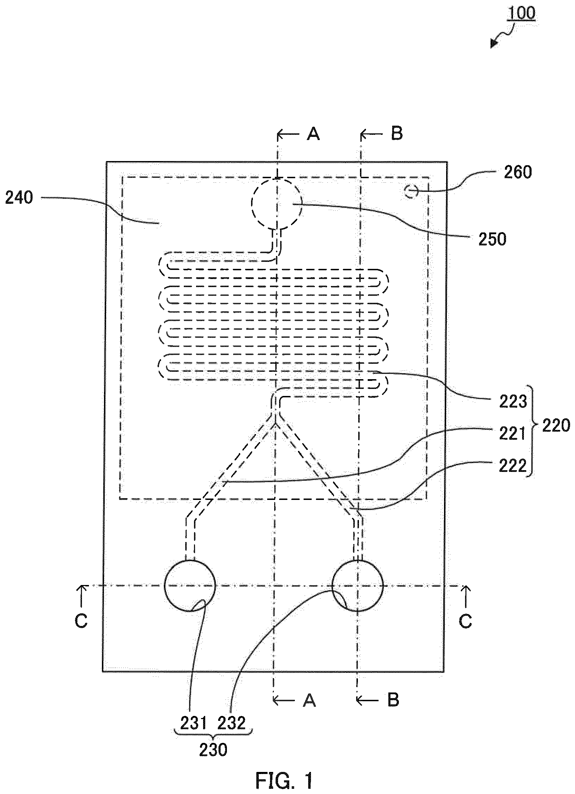

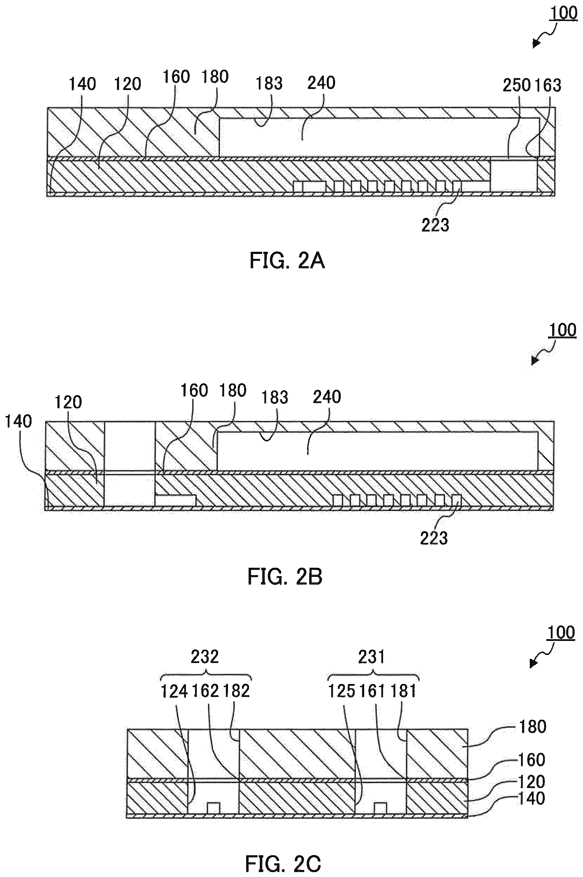

FIGS. 1 to 2C illustrate a configuration of microchannel chip 100 according to Embodiment 1 of the present invention. FIG. 1 is a plan view of microchannel chip 100. FIG. 2A is a sectional view taken along line A-A of FIG. 1, FIG. 2B is a sectional view taken along line B-B of FIG. 1, and FIG. 2C is a sectional view taken along line C-C of FIG. 1.

As shown in FIGS. 1, 2A and 2B, microchannel chip 100 is composed of first substrate 120, first film 140, second film 160 and second substrate 180. Microchannel chip 100 also includes channel 220, liquid introduction parts 230, liquid reservoir 240 and fluid discharging part 260.

Channel 220 is a channel for liquid to flow therethrough. Any liquid may flow through channel 220. Examples of the liquids include reagents and liquid samples. In addition, the viscosity of the liquid introduced to channel 220 is not limited as long as the liquid can advance in channel 220.

Channel 220 includes first branching channel 221, second branching channel 222 and combined channel 223. One end (upstream end) of first branching channel 221 communicates with first liquid introduction part 231 for introduction of liquid, and the other end (downstream end) communicates with second branching channel 222 and combined channel 223. One end (upstream end) of second branching channel 222 communicates with second liquid introduction part 232 for introduction of liquid, and the other end (downstream end) communicates with first branching channel 221 and combined channel 223. One end (upstream end) of combined channel 223 communicates with first branching channel 221 and second branching channel 222, and the other end (downstream end) communicates with communication part 250 communicating with liquid reservoir 240. Combined channel 223 and liquid reservoir 240 are disposed so as to overlap each other in plan view.

The cross-sectional area and cross-sectional shape of first branching channel 221, second branching channel 222 and combined channel 223 are not limited as long as liquid can move therethrough. The cross-sectional shapes of first branching channel 221, second branching channel 222 and combined channel 223 are, for example, a substantially rectangular shape with each side (width and depth) having a length of about several micrometers to several millimeters. In the present embodiment, both the cross-sectional areas and the cross-sectional shapes of first branching channel 221, second branching channel 222 and combined channel 223 are the same, with each of the channels having a width and depth of 50 $\mu$m. Further, first branching channel 221, second branching channel 222 and combined channel 223 each may be a channel with a width of about 1.0 mm and a depth of 0.1 mm, which allows liquid to advance therein by capillarity.

Liquid introduction parts 230 are inlets for introduction of liquid from outside to channel 220. Liquid introduction parts 230 include first liquid introduction part 231 and second liquid introduction part 232. First liquid introduction part 231 communicates with one end (upstream end) of first branching channel 221. The shape and the maximum diameter of first liquid introduction part 231 are not limited. In the present embodiment, the shape of first liquid introduction part 231 is cylindrical. In the present embodiment, the maximum outermost diameter (diameter) of first liquid introduction part 231 is set to a length so that a micro tip for introduction of liquid can be pressed in. This allows for introduction of liquid from first liquid introduction part 231 to first branching channel 221 while pressure is applied.

Second liquid introduction part 232 communicates with one end (upstream end) of second branching channel 222. The shape and the maximum outermost diameter of second liquid introduction part 232 are not limited. In the present embodiment, the shape of second liquid introduction part 232 is cylindrical. In the present embodiment, the maximum outermost diameter (diameter) of second liquid introduction part 232 is set to a length so that a micro tip for introduction of liquid can be pressed in. This allows for introduction of liquid from second liquid introduction part 232 to second branching channel 222 while pressure is applied.

Liquid reservoir 240 temporarily stores liquid. Liquid reservoir 240 communicates with the other end (downstream end) of combined channel 223 via communication part 250. The volume and the shape in plan view of liquid reservoir 240 are not limited.

Fluid discharging part 260 is an outlet for discharging fluid from liquid reservoir 240. Fluid discharging part 260 also functions as an air hole when liquid is introduced into channel 220, or enters liquid reservoir 240.

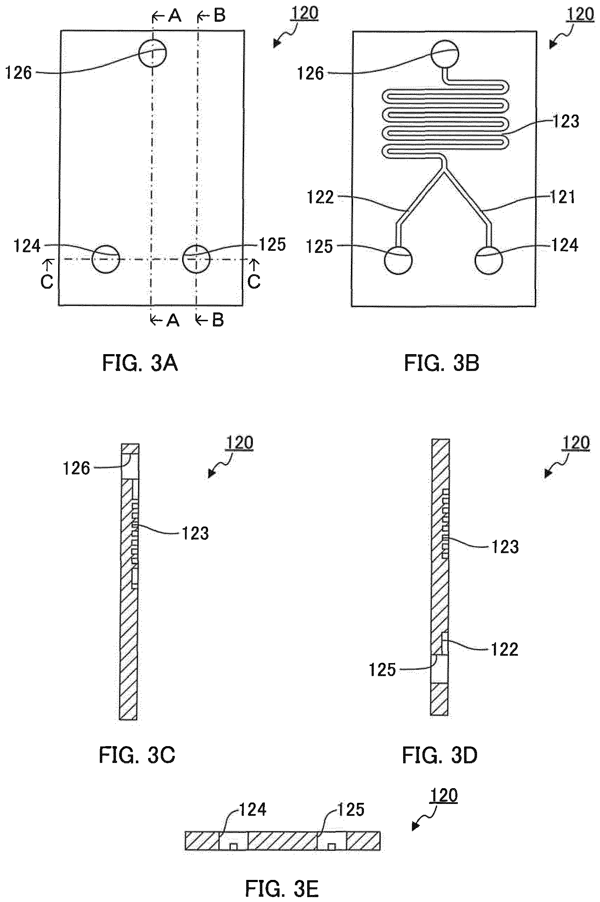

FIGS. 3A to 3E illustrate a configuration of first substrate 120. FIG. 3A is a plan view and FIG. 3B is a bottom view of first substrate 120. FIG. 3C is a sectional view taken along line A-A of FIG. 3A, FIG. 3D is a sectional view taken along line B-B of FIG. 3A, and FIG. 3E is a sectional view taken along line C-C of FIG. 3A.

As shown in FIGS. 3A to 3E, first substrate 120 is a substantially rectangular transparent substrate made of a resin. First substrate 120 includes first branching groove 121, second branching groove 122, combined groove 123, first through hole 124, second through hole 125 and third through hole 126. First branching groove 121, second branching groove 122 and combined groove 123 are formed in a first surface (front surface) of first substrate 120. First through hole 124, second through hole 125 and third through hole 126 each open at the first surface of first substrate 120 and at a second surface (rear surface) thereof, the second surface is in a front-rear relation with the first surface.

One end (upstream end) of first branching groove 121 communicates with first through hole 124, and the other end (downstream end) of first branching groove 121 communicates with second branching groove 122 and combined groove 123. One end (upstream end) of second branching groove 122 communicates with second through hole 125, and the other end (downstream end) of second branching groove 122 communicates with first branching groove 121 and combined groove 123. One end (upstream end) of combined groove 123 communicates with first branching groove 121 and second branching groove 122, and the other end (downstream end) of combined groove 123 communicates with third through hole 126.

The thickness of first substrate 120 is not limited at a region where first branching groove 121, second branching groove 122, combined groove 123, first through hole 124, second through hole 125 and third through hole 126 are not formed. The thickness of first substrate 120 at the region is, for example, in a range of 1 to 10 mm. The type of resin composing first substrate 120 is not limited, and may be appropriately selected from publicly known resins. Examples of the resins composing first substrate 120 include cycloolefin polymers (COP), cycloolefin copolymers (COC), polyethylene terephthalate, polycarbonate, polymethylmethacrylate, polyvinyl chloride, polypropylene, polyether, polyethylene, polystyrene, silicone resins and elastomers. First substrate 120 can be manufactured by, for example, injection molding.

First branching channel 221, second branching channel 222 and combined channel 223 are formed by joining the first surface (front surface) of first substrate 120 and first film 140 so as to close openings of first branching groove 121, second branching groove 122 and combined groove 123.

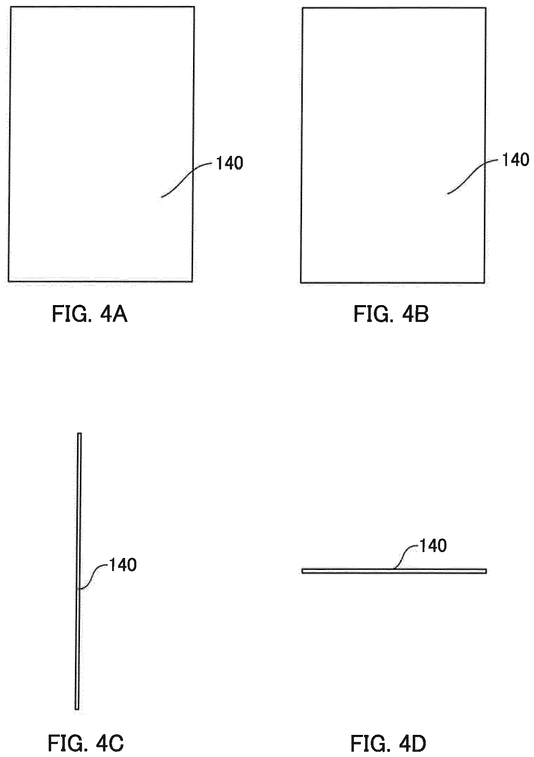

FIGS. 4A to 4D illustrate a configuration of first film 140. FIG. 4A is a plan view, FIG. 4B is a bottom view, FIG. 4C is a side view and FIG. 4D is a front view of first film 140.

As shown in FIGS. 4A to 4D, first film 140 is a substantially rectangular transparent film made of a resin, which is flexible. First film 140 is bonded to the first surface (front surface), where first branching groove 121, second branching groove 122 and combined groove 123 are formed, of first substrate 120. The type of resin composing first film 140 is not limited and may be appropriately selected from publicly known resins, as long as the surface (the surface serving as the internal wall of the channel) of first branching channel 221 allows liquid to advance therein, as well as the adhesion strength to first substrate 120, and the tolerance against the heat history and reagent during various processes can be ensured. Examples of the resins composing first film 140 include cycloolefin polymers, cycloolefin copolymers, polyethylene terephthalate, polycarbonate, polymethylmethacrylate, polyvinyl chloride, polypropylene, polyether, polyethylene, polystyrene and silicone resins. The thickness of first film 140 is not limited as long as the above-mentioned functions can be achieved, and may be appropriately set in accordance with the type (stiffness) of resin. In the present embodiment, first film 140 has a thickness of about 200 $\mu$m.

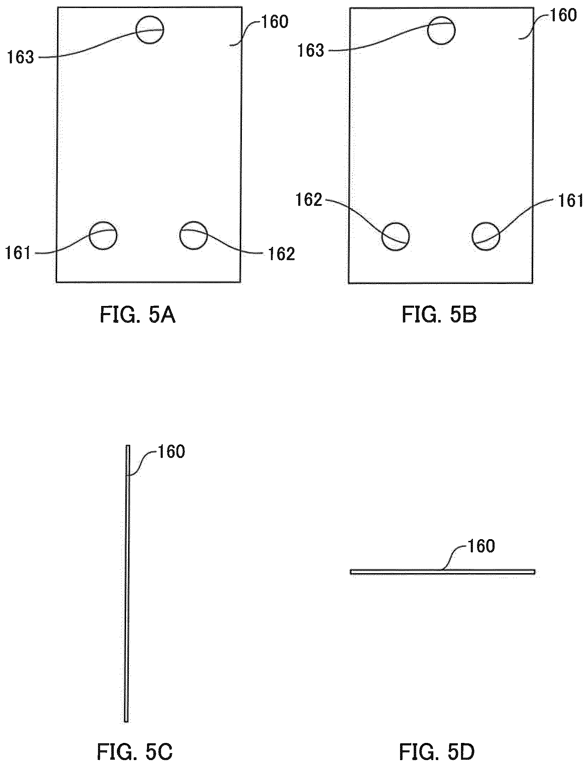

FIGS. 5A to 5D illustrate a configuration of second film 160. FIG. 5A is a plan view, FIG. 5B is a bottom view, FIG. 5C is a side view and FIG. 5D is a front view of second film 160.

As shown in FIGS. 5A to 5D, second film 160 is a substantially rectangular transparent film made of a resin, which is flexible. Second film 160 is disposed between the second surface (rear surface) of first substrate 120 and the first surface (front surface) of second substrate 180. Second film 160 includes fourth through hole 161, fifth through hole 162 and sixth through hole 163. Fourth through hole 161 communicates with first branching groove 121 via first through hole 124. Fifth through hole 162 communicates with second branching groove 122 via second through hole 125. Sixth through hole 163 communicates with combined groove 123 via third through hole 126.

Examples of the resins composing second film 160 include cycloolefin polymers, cycloolefin copolymers, polyethylene terephthalate, polycarbonate, polymethylmethacrylate, polyvinyl chloride, polypropylene, polyether, polyethylene, polystyrene, silicone resins and elastomers. The thickness of second film 160 may be appropriately set in accordance with the type (stiffness) of resin. In the present embodiment, second film 160 has a thickness of about 200 $\mu$m.

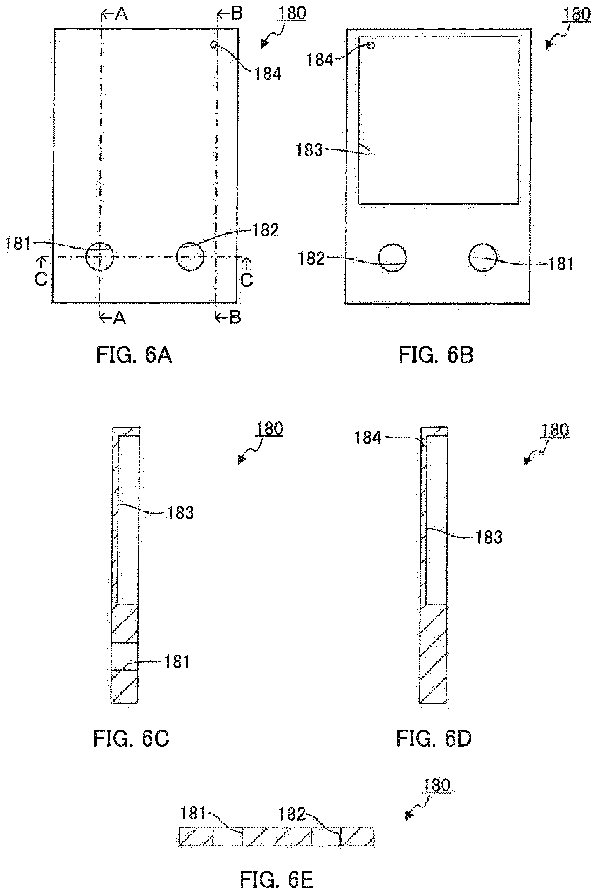

FIGS. 6A to 6E illustrate a configuration of second substrate 180. FIG. 6A is a plan view and FIG. 6B is a bottom view of second substrate 180. FIG. 6C is a sectional view taken along line A-A of FIG. 6A, FIG. 6D is a sectional view taken along line B-B of FIG. 6A, and FIG. 6E is a sectional view taken along line C-C of FIG. 6A.

As shown in FIGS. 6A to 6E, second substrate 180 includes seventh through hole 181, eighth through hole 182, recess 183 and ninth through hole 184. Seventh through hole 181 and eighth through hole 182 each open at the first surface (front surfaces) of second substrate 180 and at a second surface (rear surface) thereof, and the second surface is in a front-rear relation with the first surface. Seventh through hole 181 is formed at a position corresponding to fourth through hole 161 of second film 160 so as to have the same size as fourth through hole 161. Eighth through hole 182 is formed at a position corresponding to fifth through hole 162 of second film 160 so as to have the same size as fifth through hole 162.

Recess 183 opens at the first surface of second substrate 180, and communicates with sixth through hole 163 of second film 160. The shape in plan view, the volume and the like of recess 183 are not limited. The shape in plan view and the volume of recess 183 may be appropriately set in accordance with applications. Ninth through hole 184 is formed at the bottom surface of recess 183. Ninth through hole 184 opens at the bottom surface of recess 183 and at the second surface of second substrate 180. Ninth through hole 184 functions as fluid discharging part 260 or as an air hole when liquid is introduced.

Liquid reservoir 240 is formed by joining the second surface (rear surface) of second film 160 to the first surface (front surface) of second substrate 180 so as to close opening of recess 183. Further, liquid introduction parts 230 and fluid discharging part 260 are formed by joining the first surface (front surface) of second film 160, that is bonded to second substrate 180, to the second surface (rear surface) of first substrate 120 to which first film 140 is bonded. In a state where first film 140, first substrate 120, second film 160 and second substrate 180 are joined, combined groove 123 and recess 183 are disposed so as to overlap each other in plan view. The width of combined groove 123 is shorter than the length of recess 183 in the direction of the width at the same position as recess 183.

The thickness of second substrate 180 is not limited at a region where seventh through hole 181, eighth through hole 182, recess 183 and ninth through hole 184 are not formed. The thickness of second substrate 180 at the region is, for example, in a range of 1 to 10 mm. Examples of the resins composing second substrate 180 include cycloolefin polymers, cycloolefin copolymers, polyethylene terephthalate, polycarbonate, polymethylmethacrylate, polyvinyl chloride, polypropylene, polyether, polyethylene, polystyrene, silicone resins and elastomers. Second substrate 180 can be manufactured by, for example, injection molding.

The glass transition temperature $Tg_{1s}$ of first substrate 120, the glass transition temperature $Tg_{1f}$ of first film 140, the glass transition temperature $Tg_{2s}$ of the second substrate 180, and the glass transition temperature $Tg_{2f}$ of second film 160 satisfy the following expression (1)

$$Tg_{1s}, Tg_{2s} > Tg_{1f}, Tg_{2f} \cdots (1).$$

Any resins selected from the above-mentioned resins may be used for composing first substrate 120, first film 140, second film 160 and second substrate 180 as long as expression (1) is satisfied. Examples of combinations of commercially available resins which satisfy expression (1) include the following. ZEONEX F52R ($Tg_{1s}$: 156°C), Zeon Corporation can be used as a commercially available resin composing first substrate 120 and second substrate 180. ZEONOR Film ZF14 ($Tg_{1f}$: 136°C), Zeon Corporation can be used as a commercially available resin composing first film 140. ZEONOR 1060R ($Tg_{2f}$: 100°C), Zeon Corporation can be used as a commercially available resin composing second film 160. $Tg_{1f} \geq Tg_{2f}$-5(°C) is preferred, and $Tg_{1f} \geq Tg_{2f}$(°C) is more preferred for suppressing deformation of channel 220 in the case where the temperature for joining second film 160 to second substrate 180 is transferred to first film 140.

When the glass transition temperature $Tg_{1s}$ of first substrate 120 and the glass transition temperature $Tg_{2s}$ of second substrate 180 are lower than the glass transition temperature $Tg_{1f}$ of first film 140 and the glass transition temperature $Tg_{2f}$ of second film 160, first substrate 120 and second substrate 180 deform, and joining cannot be suitably performed.

Manufacturing Method of Microchannel Chip

The manufacturing method of microchannel chip 100 according to the present embodiment is not limited. For example, first substrate 120 and first film 140 may be joined at first joining temperature $T_1$, followed by joining of second film 160 and second substrate 180 thereto at second joining temperature $T_2$ (manufacturing method 1). First substrate 120, second film 160 and second substrate 180 may be joined at second joining temperature $T_2$, followed by joining of first film 140 thereto at first joining temperature $T_1$ (manufacturing method 2). It is necessary to set first joining temperature $T_1$ so as not to cause deformation of the shape of a channel.

(Manufacturing method 1)

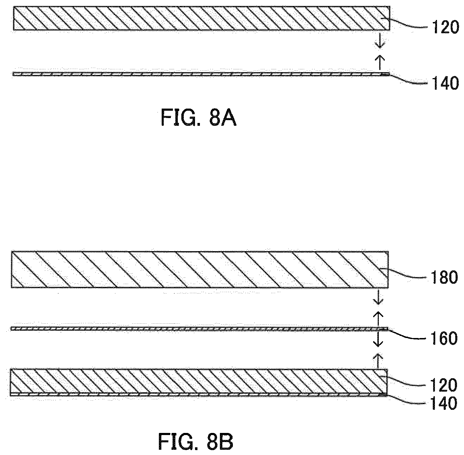

FIGS. 8A and 8B illustrate steps of manufacturing method 1. FIG. 8A illustrates the first step of manufacturing method 1, and FIG. 8B illustrates the second step of manufacturing method 1. First substrate 120 and second substrate 180 may be, for example, manufactured by injection molding using the above-mentioned resins.

As shown in FIG. 8A, in the first step, first film 140 is laminated on the first surface, where first branching groove 121, second branching groove 122 and combined groove 123 are formed, of first substrate 120, followed by joining the first surface of first substrate 120 and the second surface of the first film at first joining temperature $T_1$, and thus a joint body is obtained. Specifically, thermal fusing is performed by applying heat and pressure using heat plates from the first surface side of first film 140 and the second surface side of first substrate 120.

As shown in FIG. 8B, in the second step, the joint body composed of first substrate 120 and first film 140, second film 160 and second substrate 180 are laminated, followed by joining the second surface of first substrate 120 and the first surface of second film 160 at second joining temperature $T_2$, and joining the second surface of second film 160, which is in a front-rear relation with the first surface of second film 160, and the first surface of second substrate 180 at second joining temperature $T_2$. Specifically, thermal fusing is performed by applying heat and pressure using heat plates from the first surface side of first film 140 and the second surface side of second substrate 180. Microchannel chip 100 can be manufactured by the above steps. In these steps, thermal fusing is performed at a temperature at which first film 140 does not excessively soften, and therefore, first film 140 and first substrate 120 can be suitably joined without first film 140 entering inside the channel.

(Manufacturing method 2)

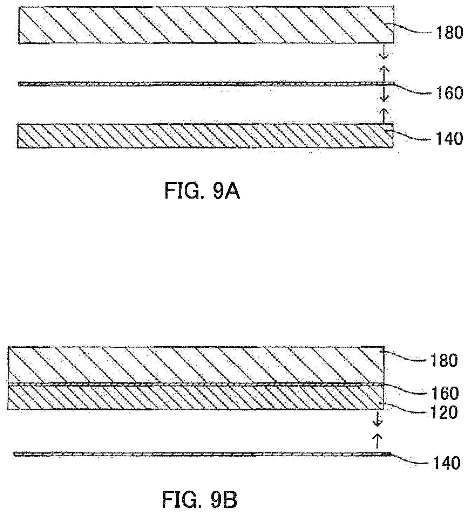

FIGS. 9A and 9B illustrate steps of manufacturing method 2. FIGS. 9A and 9B illustrate the first and second steps of manufacturing method 2, respectively. In manufacturing method 2, first substrate 120 and second substrate 180 may be manufactured by injection molding in the same manner as in manufacturing method 1.

As shown in FIG. 9A, in the first step, first substrate 120, second film 160 and second substrate 180 are laminated, followed by joining the second surface of first substrate 120 and the first surface of second film 160 at first joining temperature $T_1$, and joining the second surface of second film 160 and the first surface of second substrate 180 at first joining temperature $T_1$, and thus a joint body is obtained. Specifically, thermal fusing is performed by applying heat and pressure using heat plates from the first surface side of first substrate 120 and the second surface side of second substrate 180.

As shown in FIG. 9B, in the second step, the joint body composed of first substrate 120, second film 160 and second substrate 180, and first film 140 are laminated, followed by joining the first surface of first substrate 120 and the second surface of first film 140 at second joining temperature $T_2$. Specifically, thermal fusing is performed by applying heat and pressure using heat plates from the first surface side of first film 140 and the second surface side of second substrate 180. Microchannel chip 100 can be manufactured by the above steps.

In these steps, thermal fusing is performed at a temperature at which first film 140 does not excessively soften, and therefore, first film 140 can be suitably joined to first substrate 120 without first film 140 entering inside the channel.

The first and second steps can be simultaneously performed. That is, thermal fusing by applying heat and pressure using heat plates may be performed while first film 140, first substrate 120, second film 160 and second substrate 180 are laminated.

(Method of Handling Microchannel Chip)

A method of handling (usage) of microchannel chip 100 will now be described. Firstly, microchannel chip 100 is disposed so that first liquid introduction part 231 and second liquid introduction part 232 open upward. At this time, liquid reservoir 240 is disposed above channel 220. A micro tip, filled with liquid, of a micro pipette is pressed into first liquid introduction part 231. At this time, the outer peripheral surface of the micro tip is closely fitted to the opening of first liquid introduction part 231, and thus the micro tip is fixed to first liquid introduction part 231.

Secondly, the liquid in the micro tip is introduced into first branching channel 221 with pressure from outside. As described above, since liquid reservoir 240 is disposed above channel 220, liquid cannot reach liquid reservoir 240 unless the liquid is introduced from first liquid introduction part 231 by applying pressure.

Introduction of liquid from second liquid introduction part 232 can be performed in the same manner as in the steps of introduction of liquid from first liquid introduction part 231. A micro tip, filled with liquid, of a micro pipette is pressed into second liquid introduction part 232. At this time, the outer peripheral surface of the micro tip is closely fitted to the opening of second liquid introduction part 232, and thus the micro tip is fixed to second liquid introduction part 232. The liquid in the micro tip is then introduced into second branching channel 222 with pressure from outside.

Introductions of liquid from first liquid introduction part 231 and second liquid introduction part 232 may be performed at the same time or different times.

These procedures allow for introduction of liquid to liquid reservoir 240 via first branching channel 221 and second branching channel 222.

(Effect)

As described above, first substrate 120 and second substrate 180 can be suitably joined in microchannel chip 100 according to Embodiment 1 because second film 160 and second substrate 180 are disposed to face the second surface, where first branching groove 121 is not formed, of first substrate 120; and $Tg_{1s}$, $Tg_{2s} > Tg_{1f}$, $Tg_{2f}$ is satisfied when a glass transition temperature of the first substrate is $Tg_{1s}$, a glass transition temperature of the first film is $Tg_{1f}$, a glass transition temperature of the second substrate is $Tg_{2s}$, and a glass transition temperature of the second film is $Tg_{2f}$.

[Embodiment 2]

Microchannel chip 300 according to Embodiment 2 is different from microchannel chip 100 according to Embodiment 1 in the shapes of a second surface (rear surface) of first substrate 320 and a first surface (front surface) of second substrate 380. The configurations same as those of microchannel chip 100 according to Embodiment 1 are given the same symbols as those of microchannel chip 100, and the description thereof is omitted.

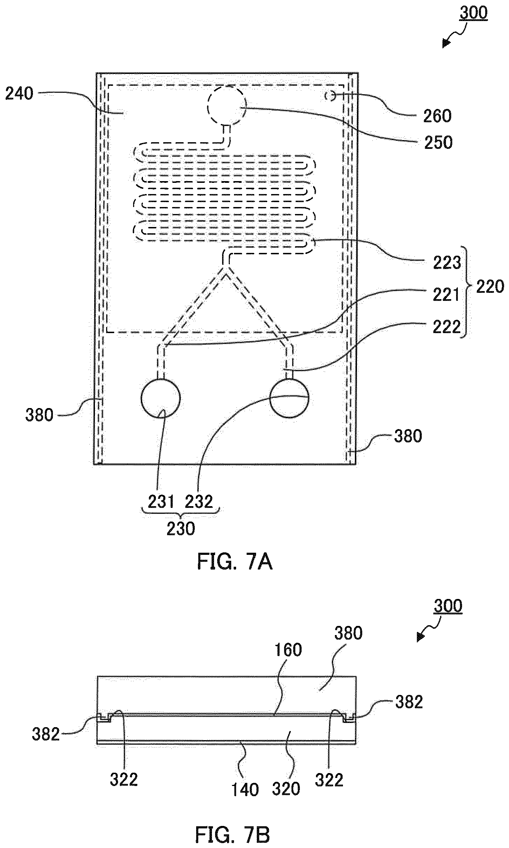

FIGS. 7A and 7B illustrate a configuration of microchannel chip 300 according to Embodiment 2. FIG. 7A a plan view and FIG. 7B is a front view of microchannel chip 300. As shown in FIGS. 7A and 7B, microchannel chip 300 according to Embodiment 2 includes first film 140, first substrate 320, second film 160 and second substrate 380. Microchannel chip 300 also includes channel 220, liquid introduction part 230, liquid reservoir 240 and fluid discharging part 260.

First substrate 320 includes first branching groove 121, second branching groove 122, combined channel 223, first through hole 124, second through hole 125 and third through hole 126. Recessed line(s) 322 is formed in the second surface (rear surface) of first substrate 320. The number and shape of recessed line(s) 322 are not limited. In the present embodiment, the number of recessed lines 322 is two. Recessed line 322 is disposed so that the ends thereof reach opposite two side surfaces. Recessed lines 322 may or may not be disposed parallel to each other. In the present embodiment, two recessed lines 322 are disposed parallel to each other. The cross-sectional shape of recessed line 322 is not limited. In the present embodiment, the cross-sectional shape of recessed line 322 is rectangular.

Second substrate 380 includes seventh through hole 181, eighth through hole 182, recess 183 and ninth through hole 184. Protruding lines 382 are formed on the first surface (front surface) of second substrate 380. Protruding line 382 is disposed at a position corresponding to recessed line 322 which is formed in first substrate 320. The number of protruding lines 382 is the same as that of recessed lines 322. Further, the cross-sectional shape of protruding line 382 is complementary to that of recessed line 322. In the present embodiment, the cross-sectional shape of protruding line 382 is rectangular. It is preferred that recess 183 is disposed at a region of second substrate 380 where seventh through hole 181, eighth through hole 182 and protruding line 382 are not formed. In the present embodiment, protruding line 382 is disposed at a region of second substrate 380 where seventh through hole 181, eighth through hole 182 and recess 183 are not formed.

Microchannel chip 300 according to the present embodiment can be manufactured in the same manner as in the steps for microchannel chip 100 according to Embodiment 1.

(Effect)

As described above, microchannel chip 300 according to Embodiment 2 has the same effects as that of microchannel chip 100 according to Embodiment 1. Further, since the second surface of first substrate 320 and the first surface of second substrate 380 are formed to be complementary in microchannel chip 300 according to Embodiment 2, the surface area of an area where first substrate 320 and second substrate 380 are in contact with each other becomes larger, and thus first substrate 320 and second substrate 380 can be more suitably joined.

While films 140 and 160, and substrates 120 and 180 are joined by thermal fusing in Embodiments 1 and 2, the surfaces of substrates 120 and 180 may be previously subjected to plasma or corona treatment in addition to thermal fusing. This allows the crosslinking strength to become increased during joining between substrates 120 and 180, and films 140 and 160, and thus first substrate 120 and second substrate 180 can be more strongly joined. A solvent such as acetone or ethanol, or an adhesive may be applied between films 140 and 160, and substrates 120 and 180. Joining by means of a laser may be used together.

Before the above-mentioned thermal fusing, a glass transition temperature(s) of first film 140 and/or second film 160 may be lowered by irradiation of first film 140 and/or second film 160 with ultraviolet rays. This allows for suppression of production costs by lowering the temperature required for the thermal fusing.

While recess 183 is disposed in second substrate 180 in Embodiments 1 and 2, another channel (second channel) communicating with channel 220 may be disposed in second substrate 180. Further, while an example in which two substrates 120 and 180, and two films 140 and 160 are joined is described in Embodiments 1 and 2, the number of substrates and films each may be 3 or more.

This application claims priority based on Japanese Patent Application No. 2014-250262, filed on December 10, 2014, the entire contents of which including the specification and the drawings are incorporated herein by reference.

Industrial Applicability

The fluid handling device of the present invention is particularly advantageous, for example, as a microchannel chip used in scientific fields, medical fields and the like.

Reference Signs List

100, 300 microchannel chip
120, 320 first substrate
121 first branching groove
122 second branching groove
123 combined groove
124 first through hole
125 second through hole
126 third through hole
140 first film
160 second film
161 fourth through hole
162 fifth through hole
163 sixth through hole
180, 380 second substrate
181 seventh through hole
182 eighth through hole
183 recess
184 ninth through hole
220 channel
221 first branching channel
222 second branching channel
223 combined channel
230 liquid introduction parts
231 first liquid introduction part
232 second liquid introduction part
240 liquid reservoir
250 communication part
260 fluid discharging part
322 recessed line
382 protruding line

**Claims**

1. A fluid handling device comprising:

 a resin-made first substrate having a first surface in which a groove is formed;
 a resin-made first film joined to the first surface of the first substrate;
 a resin-made second film having a first surface joined to a second surface of the first substrate, the second surface of the first substrate being in a front-rear relation with the first surface of the first substrate; and
 a resin-made second substrate joined to a second surface of the second film, the second surface of the second film being in a front-rear relation with the first surface of the second film,
 wherein a recess overlapping the groove in plan view is formed in a surface of the second substrate, the surface being joined to the second film, and
 following expression (1) is satisfied

$$Tg_{1s}, Tg_{2s} > Tg_{1f}, Tg_{2f} \cdots (1)$$

 wherein $Tg_{1s}$ represents a glass transition temperature of the first substrate, $Tg_{1f}$ represents a glass transition temperature of the first film, $Tg_{2s}$ represents a glass transition temperature of the second substrate, and $Tg_{2f}$ represents a glass transition temperature of the second film.

2. The fluid handling device according to claim 1, wherein the glass transition temperature of the first film represented by $Tg_{1f}$ and the glass transition temperature of the second film represented by $Tg_{2f}$ satisfy following expression (2)

$$Tg_{1f} \geq Tg_{2f} - 5 \cdots (2).$$

3. The fluid handling device according to claim 2, wherein the glass transition temperature of the first film represented by $Tg_{1f}$ and the glass transition temperature of the second film represented by $Tg_{2f}$ satisfy following expression (3)

$$Tg_{1f} \geq Tg_{2f} \cdots (3).$$

4. The fluid handling device according to any one of claims 1 to 3, wherein a width of the groove is shorter than a length of the recess in a direction of the width at a position of the recess.

5. The fluid handling device according to any one of claims 1 to 4, wherein the first substrate and the second substrate are injection molded articles.

6. The fluid handling device according to any one of claims 1 to 5, wherein the first film and the second film are flexible.

7. The fluid handling device according to any one of claims 1 to 6, wherein the second film includes a through hole which communicates with the recess.

8. A method of manufacturing the fluid handling device according to any one of claims 1 to 7, wherein joining of the first film and the first substrate, joining of the first substrate and the second film, and joining of the second film and the second substrate are each performed by thermal fusing.

FIG. 1

100

140  120  160  180    183   240          250 163

FIG. 2A

100

120      160 180  183   240

140

223

FIG. 2B

100

232                  231

124 162 182      125 161 181

180

160
120
140

FIG. 2C

FIG. 3A

FIG. 3B

FIG. 3C

FIG. 3D

FIG. 3E

140

FIG. 4A

140

FIG. 4B

140

FIG. 4C

140

FIG. 4D

FIG. 5A

FIG. 5B

FIG. 5C

FIG. 5D

FIG. 6A

FIG. 6B

FIG. 6C

FIG. 6D

FIG. 6E

300

240

260

250

223
221  } 220
222

380

380

231  232
230

FIG. 7A

300

160  380

382

382

322  322

140  320

FIG. 7B

120

140

## FIG. 8A

180

160

120
140

## FIG. 8B

FIG. 9A

FIG. 9B

**INTERNATIONAL SEARCH REPORT**

| International application No. |
|---|
| PCT/JP2015/080581 |

A. CLASSIFICATION OF SUBJECT MATTER
*B01J19/00*(2006.01)i, *B29C65/02*(2006.01)i, *B81B3/00*(2006.01)i, *G01N35/08*(2006.01)i, *G01N37/00*(2006.01)i

According to International Patent Classification (IPC) or to both national classification and IPC

B. FIELDS SEARCHED

Minimum documentation searched (classification system followed by classification symbols)
B01J19/00, B29C65/02, B81B3/00, G01N35/08, G01N37/00

Documentation searched other than minimum documentation to the extent that such documents are included in the fields searched

| | | | |
|---|---|---|---|
| Jitsuyo Shinan Koho | 1922–1996 | Jitsuyo Shinan Toroku Koho | 1996–2016 |
| Kokai Jitsuyo Shinan Koho | 1971–2016 | Toroku Jitsuyo Shinan Koho | 1994–2016 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y | JP 2007-136292 A  (National Institute of Advanced Industrial Science and Technology), 07 June 2007 (07.06.2007), claims; paragraphs [0054], [0058], [0066]; fig. 2 (Family: none) | 1-4,7-8<br>5-6 |
| Y | JP 2013-10076 A  (Sumitomo Bakelite Co., Ltd.), 17 January 2013 (17.01.2013), paragraphs [0015], [0023] (Family: none) | 5-6 |
| A | JP 09-502795 A  (Pharmacia Biotech AB), 18 March 1997 (18.03.1997), & US 6126765 A          & WO 1994/029400 A1 & EP 738306 A1 | 1-8 |

☒ Further documents are listed in the continuation of Box C.　　☐ See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search<br>18 January 2016 (18.01.16) | Date of mailing of the international search report<br>26 January 2016 (26.01.16) |
|---|---|
| Name and mailing address of the ISA/<br>Japan Patent Office<br>3-4-3,Kasumigaseki,Chiyoda-ku,<br>Tokyo 100-8915,Japan | Authorized officer<br><br>Telephone No. |

Form PCT/ISA/210 (second sheet) (January 2015)

**INTERNATIONAL SEARCH REPORT**

| International application No. |
|---|
| PCT/JP2015/080581 |

C (Continuation).   DOCUMENTS CONSIDERED TO BE RELEVANT

| Category* | Citation of document, with indication, where appropriate, of the relevant passages | Relevant to claim No. |
|---|---|---|
| A | WO 2014/027435 A1  (Enplas Corp.),<br>20 February 2014 (20.02.2014),<br>& US 2015/0300985 A1    & EP 2884142 A1 | 1-8 |
| A | WO 2012/011262 A1  (Enplas Corp.),<br>26 January 2012 (26.01.2012),<br>& US 2013/0121894 A1    & CN 103003686 A | 1-8 |

Form PCT/ISA/210 (continuation of second sheet) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2008304352 A
- JP 2014250262 A